# EUROPÄISCHE PATENTSCHRIFT

(11) **EP 1 503 435 B1**
(45) Veröffentlichungstag und Bekanntmachung des Hinweises auf die Patenterteilung: **22.10.2008**
(21) Anmeldenummer: 04015632.5
(22) Anmeldetag: 02.07.2004
(51) Int. Cl.: H01L 41/083, H01L 41/22

(54) **Verfahren zur Herstellung eines Piezoaktors**
Manufacturing method for a piezoelectric actuator
Méthode de fabrication d'un actionneur piézo-électrique

(30) Priorität: 31.07.2003 DE 10335023
(43) Veröffentlichungstag der Anmeldung: 02.02.2005
(73) Patentinhaber: ROBERT BOSCH GMBH, 70442 Stuttgart (DE)
(72) Erfinder: Boecking, Friedrich, 70499 Stuttgart (DE)

(56) Entgegenhaltungen:
- DE-A1- 4 201 937
- US-A- 4 438 364
- US-A- 4 932 119

## Beschreibung

### Stand der Technik

Die Erfindung betrifft ein Verfahren zur Herstellung eines Piezoaktors, beispielsweise zur Betätigung eines mechanischen Bauteils wie ein Ventil oder dergleichen, nach den gattungsgemäßen Merkmalen des Hauptanspruchs.

Es ist beispielsweise aus der DE 199 28 177 A1 bekannt, dass unter Ausnutzung des sogenannten Piezoeffekts ein Piezoelement zur Steuerung des Nadelhubes eines Ventils oder dergleichen aus einem Material mit einer geeigneten Kristallstruktur aufgebaut werden kann. Bei Anlage einer äußeren elektrischen Spannung erfolgt eine mechanische Reaktion des Piezoelements, die in Abhängigkeit von der Kristallstruktur und der Anlagebereiche der elektrischen Spannung einen Druck oder Zug in eine vorgebbare Richtung darstellt.

Der Aufbau eines solchen Piezoaktors erfolgt beim Stand der Technik in mehreren Schichten als sogenannter Multilayer-Aktor, wobei Innenelektroden, über die die elektrische Spannung aufgebracht wird, jeweils in Wirkrichtung zwischen den Schichten angeordnet und mittels Außenelektroden kontaktiert werden. Insbesondere bei einer Ansteuerung der eingangs erwähnten Ventilnadeln kann es vorkommen, dass relativ lange und schlanke Piezoaktoren benötigt werden. Aufgrund des Multilayer-Aufbaus der Piezolagen mit den kristallinen Schichten und den dazwischenliegenden Innenelektroden ist es hierbei oft nicht möglich den gesamten Piezoaktor in einem Arbeitsgang durchgehend zu fertigen.

Aus DE 4 201 937 ist es bekannt, einen Piezoaktor aus Teilpiezoaktoren herzustellen.

### Vorteile der Erfindung

Der eingangs beschriebene Piezoaktor, der beispielsweise zur Betätigung eines mechanischen Bauteils verwendbar sein kann, weist einen Mehrschichtaufbau von Piezolagen mit dazwischen angeordneten Innenelektroden auf und ist mit einer wechselseitigen seitlichen Kontaktierung der Innenelektroden mit Außenelektroden versehen. In vorteilhafter Weise sind insbesondere zur Realisierung von langen und schlanken Piezoaktoren eine Anzahl von einzeln hergestellten Teilpiezoaktoren in Wirkrichtung des Piezoaktors in Reihe geschaltet, so dass auf besonders kostengünstige Weise ein längerer und schlankerer Piezoaktor hergestellt werden kann.

Die mindestens zwei- bis x-fache Anordnung von Teilpiezoaktoren kann auf einfache Weise durch eine mechanische Verbindung von inaktiven Bereichen am jeweiligen Kopfund am Fußende eines jeden Teilpiezoaktors realisiert werden, wobei die Außenelektroden der Teilpiezoaktoren dann über eine entsprechende Elektrodengestaltung jeweils bei gleicher Polarität miteinander elektrisch verbunden werden können und diese gegebenenfalls auch zur mechanischen Verbindung beitragen oder diese ganz realisieren.

Besonders vorteilhaft ist es hierbei, wenn die Außenelektroden Siebelektroden, vorzugsweise aus Invar, sind. Mit dieser Materialwahl in Form eines Invar-Siebes kann in vorteilhafter Weise erreicht werden, dass bei einem fast gleichen thermischen Ausdehnungskoeffizienten der Außenelektrode wie des Piezoaktors die mechanische Beanspruchung des gesamten Piezoaktors vermindert wird.

Das Herstellungsverfahren zum Bau eines erfindungsgemäßen Piezoaktors ist besonders einfach, wenn zunächst in einem ersten Herstellungsschritt die Teilpiezoaktoren hergestellt werden, dann in einem zweiten Herstellungsschritt die Teilpiezoaktoren mechanisch über die inaktiven Bereiche miteinander verbunden werden und in einem dritten Herstellungsschritt die Außenelektroden an die Kontaktierungsflächen der jeweiligen Innenelektroden am Piezoaktor aufgebracht werden.

### Zeichnung

Ein Ausführungsbeispiel des erfindungsgemäßen Piezoaktors wird anhand der Zeichnung erläutert. Es zeigen:
Figur 1 einen Schnitt durch einen Piezoaktor mit drei Teilpiezoaktoren und
Figur 2 einen Detail-Ausschnitt A durch eine Verbindungsstelle zweier Teilpiezoaktoren mit einem gemeinsamen Invarsieb als Außenelektrode.

### Beschreibung des Ausführungsbeispiels

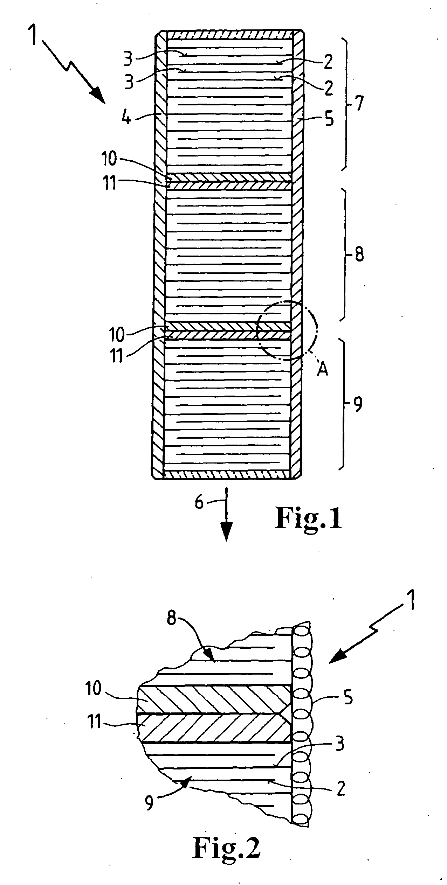

In Figur 1 ist ein Piezoaktor 1 gezeigt, der in an sich bekannter Weise aus Piezofolien eines Quarzmaterials mit einer geeigneten Kristallstruktur aufgebaut ist, so dass unter Ausnutzung des sogenannten Piezoeffekts bei Anlage einer äußeren elektrischen Spannung an Elektroden 2 und 3 über Außenelektroden 4 und 5 eine mechanische Reaktion des Piezoaktors 1 in Wirkrichtung 6 erfolgt. Diese für sich gesehen aus dem Stand der Technik bekannte Anordnung ist hier nur zum Verständnis im oberen Bereich eines Teilpiezoaktors 7 angedeutet; sie erstreckt sich jedoch über den ganzen Teilpiezoaktor 7 und den gesamten Piezoaktor 1.

Weiterhin ist aus der Figur 1 erkennbar, dass noch Teilpiezoaktoren 8 und 9 in der Wirkrichtung 6 des Piezoaktors 1 hintereinander geschaltet sind. Die Teilpiezoaktoren 7, 8 und 9 liegen über ihre inaktiven Kopf- und Fußbereiche 10 und 11 jeweils aneinander.

Aus Figur 2 ist der Verbindungsbereich zwischen den Teilpiezoaktoren 8 und 9 gemäß Detail A der Figur 1 vergrößert dargestellt, wobei zu erkennen ist, dass die jeweiligen Kopf- bzw. Fußbereiche 10 und 11 mechanisch aneinander liegen, gegebenenfalls auch fest miteinander verbunden sind. Die Außenelektrode 5 ist hier als Invar-Siebelektrode ausgeführt und stellt somit eine elektrische und ev. bei entsprechender Auslegung auch eine mechanische Verbindung zwischen den Teilpiezoaktoren 8 und 9 her.

## Patentansprüche

1. Verfahren zur Herstellung eines Piezoaktors, der einen Mehrschichtaufbau von Piezolagen mit dazwischen angeordneten Innenelektroden (2, 3) und eine wechselseitige seitliche Kontaktierung der Innenelektroden (2, 3) mit Außenelektroden (4, 5) hat, wobei eine Anzahl von einzeln hergestellten Teilpiezoaktoren (7, 8, 9) in Wirkrichtung (6) des Piezoaktors (1) in Reihe geschaltet sind, wobei
- in einem ersten Herstellungsschritt die Teilpiezoaktoren (7, 8, 9) hergestellt werden und
- in einem zweiten Herstellungsschritt die Teilpiezoaktoren (7, 8, 9) mechanisch über die inaktiven Bereiche miteinander verbunden werden,
**dadurch gekennzeichnet,**
**dass** in einem dritten Herstellungsschritt die Außenelektroden (4, 5) an die Kontaktierungsstellen der jeweiligen Innenelektroden (2, 3) am Piezoaktor (1) aufgebracht werden.

## Claims

1. Method for producing a piezoelectric actuator, which has a multilayer structure of piezoelectric layers with inner electrodes (2, 3) arranged in between and reciprocal lateral contact of the inner electrodes (2, 3) with outer electrodes (4, 5), a number of individually produced piezoelectric part-actuators (7, 8, 9) being connected in series in the operating direction (6) of the piezoelectric actuator (1), wherein
- in a first production step, the piezoelectric part-actuators (7, 8, 9) are produced and
- in a second production step, the piezoelectric part-actuators (7, 8, 9) are mechanically connected to one another via the inactive regions,
**characterized in that**
in a third production step, the outer electrodes (4, 5) are applied to the contacting locations of the respective inner electrodes (2, 3) on the piezoelectric actuator (1).

## Revendications

1. Procédé de fabrication d'un actionneur piézoélectrique ayant une structure multicouche formée de couches piézoélectriques avec interposition d'électrodes intérieures (2, 3) et d'une mise en contact latérale sur côté alterné des électrodes intérieures (2, 3) à des électrodes extérieures (4, 5),
un certain nombre d'actionneurs piézoélectriques partiels (7, 8, 9), fabriqués séparément, étant branchés en série dans la direction active (6) des actionneurs piézoélectriques (1), et
- dans une première étape de fabrication, on fabrique les actionneurs piézoélectriques partiels (7, 8, 9), et
- dans une seconde étape de fabrication, on relie mécaniquement les actionneurs piézoélectriques partiels (7, 8, 9) par des zones inactives,
**caractérisé en ce que**
dans une troisième étape de fabrication, on applique les électrodes extérieures (4, 5) aux points de contact des électrodes intérieures (2, 3) respectives sur l'actionneur piézoélectrique (1).
